## Europäisches Patentamt

(19) **European Patent Office**

**Office européen des brevets**

(11) Publication number: **0 196 245**
**B1**

(12) # EUROPEAN PATENT SPECIFICATION

(45) Date of publication of the patent specification:
**25.10.89**

(21) Application number: **86400366.0**

(22) Date of filling: **21.02.86**

(51) Int. Cl.⁴: **H 01 L 29/207,** H 01 L 29/36, H 01 L 21/203

(54) Compound semiconductor layer having high carrier concentration and method of forming same.

(30) Priority: **22.02.85 JP 33862/85**

(43) Date of publication of application:
**01.10.86 Bulletin 86/40**

(45) Publication of the grant of the patent:
**25.10.89 Bulletin 89/43**

(84) Designated Contracting States:
**DE FR GB**

(56) References cited:
**EP-A-0 183 146**

**JOURNAL OF THE ELECTOCHEMICAL SOCIETY,
vol. 128, no. 2, February 1981, pages 400-410,
Manchester, New Hampshire, US; K. PLOOG et al.:
"The use of Si and Be impurities for novel periodic
doping structures in GaAs grown by molecular
beam epitaxy"
THIN SOLID FILMS, vol. 118, no. 2, August 1984,
pages 117-127, Lausanne, CH; D.L. MILLER "III-V
structures grown by molecular beam epitaxy for
high speed devices"
JOURNAL OF APPLIED PHYSICS, vol. 51, no. 1,
January 1980, pages 383-387, New York, US; C.E.C.
WOOD et al.: "Complex free-carrier profile
synthesis by "atomic-plane" doping of MBE GaAs"**

(73) Proprietor: **FUJITSU LIMITED, 1015, Kamikodanaka
Nakahara- ku, Kawasaki- shi Kanagawa 211 (JP)**

(72) Inventor: **Sasa, Shigehiko, 2-12, Sakuradai
3-chome, Isehara- shi Kanagawa 259- 11 (JP)**
Inventor: **Kondo, Kazuhiro, 1036- 3, Aina, Atsugi-
shi Kanagawa 243 (JP)**
Inventor: **Muto, Shunichi, Takamori Gaden 204 849-
3, Takamori, Isehara- shi Kanagawa 259- 11 (JP)**

(74) Representative: **Descourtieux, Philippe, CABINET
BEAU de LOMENIE 55 rue d'Amsterdam, F-75008
Paris (FR)**

## Description

### Background of the Invention

#### 1) Field of the Invention

The present invention relates to a compound semiconductor layer, such as gallium arsenide (GaAs) and aluminum gallium arsenide (AlGaAs) formed by a molecular beam epitaxy (MBE) process. More particularly, it relates to a doping method for a compound semiconductor layer having a high carrier concentration.

#### 2) Description of the Related Art

A compound semiconductor such as GaAs has a carrier mobility higher than that of a silicon (Si) semiconductor widely used for semiconductor devices, so a compound semiconductor contributes toward high speed operation of semiconductor devices comprising field effect transistors (FET's) or bipolar transistors. Furthermore, in an optical semiconductor device, such as a laser and a photo diode, compound semiconductors, such as GaAs and AlGaAs, are used for forming a suitable energy band condition corresponding to a desired light.

The MBE process can be used to form (i.e., grow) a compound semiconductor layer of a semiconductor device, such as a low noise Schottky barrier GaAs FET for microwaves, a high electron mobility transistor (HEMT), and a GaAs/AlGaAs double heterojunction laser, because the MBE process can provide the device with a properties superior to those by the liquid phase epitaxy (LPE) process or vapor phase epitaxy process.

The dopant (i.e., impurity) for making the compound semiconductor, such as GaAs and AlGaAs, an N-type conductivity is Si, germanium (Ge), tin (Sn), sulfur (S), selenium (Se), or tellurium (Te). The use of S, Se, or Te of group VI involves the use of a compound thereof. Ge can make the compound semiconductor a P-type conductivity depending upon growth conditions. Sn cannot easily form a donor profile with a sharp reduction. Therefore, Si is usually used. Other dopants making the compound semiconductor a P-type conductivity is beryllium (Be), magnesium (Mg), manganese (Mn), or zinc (Zn). Be is usually used.

A compound semiconductor layer (e.g., a GaAs layer) formed by the MBE process can be doped with a dopant by the following methods.

First, when the GaAs layer is grown on a GaAs substrate by bombarding the substrate with a Ga molecular beam and an As molecular beam, an Si or Be molecular beam impinges on the substrate, so that the obtained GaAs layer is uniformly doped with Si or Be. The growing and the doping are simultaneously carried out, for example, under the following conditions: a temperature of the GaAs substrate of 500°C to 700°C, a temperature of an effusion cell for As of 300°C to 400°C, a temperature of an effusion cell for Ga of 900°C to 1100°C, and a temperature of an effusion cell for Si (or Be) of 1100°C to 1350°C (or 1100°C to 1350°C). The GaAs layer is formed at a growth rate of approximately 0.5 μm/h. The formed N-type GaAs layer doped with Si has a carrier electron concentration (density) $N$ of up to $7 \times 10^{18}$ cm$^{-3}$. Although the Si doping concentration can be increased, the maximum value of $7 \times 10^{18}$ cm$^{-3}$ is not increased because of lowering of an activation coefficient of doped Si. The formed P-type GaAs layer doped with Be has a carrier hole concentration (density) $N$ of up to $5 \times 10^{19}$ cm$^{-3}$. Although the Be doping concentration can be increased, the maximum value of $5 \times 10^{19}$ cm$^{-3}$ is not increased because of the reduction of the activation coefficient of the doped Be.

Second, a GaAs MBE layer is doped with a dopant (Ge) by a so-called atomic plane doping process (cf. C.E.C. Wood et al. Complex free-carrier profile synthesis by "atomic-plane" doping of MBE GaAs, J. Appl. Phys. Vol. 51, No. 1 (1980), pp. 383 - 387). In this case, the growth of the GaAs layer is suspended by stopping the Ga molecular beam (i.e., closing an effusion cell for Ga by a shutter) and simultaneouly making the dopant molecular beam impinge on the GaAs surface, so that the dopant atoms are accommodated in a virtually flat single atomic plane. Then, the dopant molecular beam is stopped and the Ga molecular beam is resumed to grow the GaAs layer. The formation of the atomic plane is repeated and the Ga atomic planes are introduced into a grown GaAs layer. The GaAs MBE layer including Ga atomic planes attains a carrier concentration $N$ on the order of $1 \times 10^{17}$ cm$^{-3}$.

Third, the doping of the dopant into the GaAs MBE layer can be carried out by a conventional ion-implantation method. The implanted dopant atoms are activated and crystal defects are corrected by annealing at a temperature of from 800°C to 850°C. In this case, the activation coefficient of implanted dopant atoms is low, so that the carrier concentration $N$ is lower than with the above-mentioned doping manners. For example, the obtained carrier electron concentration $N$ of the GaAs layer doped with Si can attain the maximum value range of $1 \times 10^{18}$ - $2 \times 10^{18}$ cm$^{-3}$.

### Summary of the Invention

An object of the present invention is to increase a carrier concentration of a compound semiconductor (e.g., GaAs) layer.

A still other object of the present invention is to improve properties of a semiconductor device comprising a compound semiconductor layer which has an increased carrier concentration, resulting in decreased resistants (e.g., a resistant of the compound semiconductor layer itself and a contact resistant) and an increased electric current.

The above-mentioned and other objects of the present invention are attained by providing a compound semiconductor layer of GaAs or AlGaAs having atomic planes of dopant therein, each of the atomic planes having a sheet dopant concentration $N_{sd}$ of $2 \times 10^{12}$ cm$^{-2}$ or more and an interval between the atomic planes from each other of 6 nm or less, the carrier concentration of said GaAs or AlGaAs layer being $7 \times 10^{18}$ cm$^{-3}$ or more.

The compound semiconductor (GaAs or AlGaAs) is formed by the MBE process and by repeated atomic plane doping in the course of the MBE growth, the atomic plane doping being carried out by using a molecular beam of a dopant at a sheet dopant concentration $N_{sd}$ of $2 \times 10^{12}$ cm$^{-2}$ or more at intervals of 6 nm or less.

It is preferable to carry out the atomic plane doping by suspending the growth of GaAs or AlGaAs by stopping the molecular beam of Ga (and molecular beam of Al) and simultaneously by bombarding the surface of the growing GaAs or AlGaAs layer with a molecular beam of a dopant (Si or Be) to attain the desired dopant sheet concentration of the atomic plane. It is possible to carry out the atomic plane doping by bombarding the surface of the growing GaAs or AlGaAs layer with a strong molecular beam of a dopant in a short term without suspending the MBE growth.

It is preferable that a N-type GaAs (or AlGaAs) layer incorporate Si atomic planes each of which has a sheet Si concentration $N_{sd}$ of $2 \times 10^{12}$ cm$^{-2}$ or more and is spaced from the next by 6 nm or less. The Si sheet concentration and the interval (distance between neighboring atomic planes) can be controlled so as to obtain a carrier electron concentration N of the N-type GaAs (AlGaAs) layer of $7 \times 10^{18}$ cm$^{-3}$ or more.

It is also preferable that an p-type GaAs (AlGaAs) layer incorporate Be atomic planes of $5 \times 10^{12}$ cm$^{-2}$ or more at intervals of 4 nm or less. The Be sheet concentration and the interval can be controlled so as to obtain a carrier hole concentration of the P-type GaAs (AlGaAs) layer of $5 \times 10^{19}$ cm$^{-3}$ or more.

## Brief Description of the Drawings

The present invention will become more apparent from the description of the preferred embodiments set forth below with reference to the accompanying drawings, in which:

Figs. 1a to 1c are schematic views of arrangements of atoms forming a GaAs layer;

Fig. 2 is a graph showing a relationship between a sheet dopant (Si) concentration $N_{sd}$ and a sheet electron concentration $N_s$ of an N-type GaAs layer incorporating an Si atomic plane;

Fig. 3 is a graph showing the relationship between a sheet dopant (Be) concentration $N_{sd}$ and a sheet hole concentration $N_s$ of a P-type GaAs layer incorporating a Be atomic plane;

Fig. 4 is a graph showing the relationship between the interval between Si atomic planes and carrier electron concentration N of an N-type GaAs layer incorporating 20 Si atomic planes; and

Fig. 5 is a graph showing the relationship between interval between Be atomic planes and the carrier hole concentration N of a P-type GaAs layer incorporating 20 Be atomic planes.

## Description of Preferred Embodisment

Before describing the preferred embodiments of the present invention, atomic plane doping is explained.

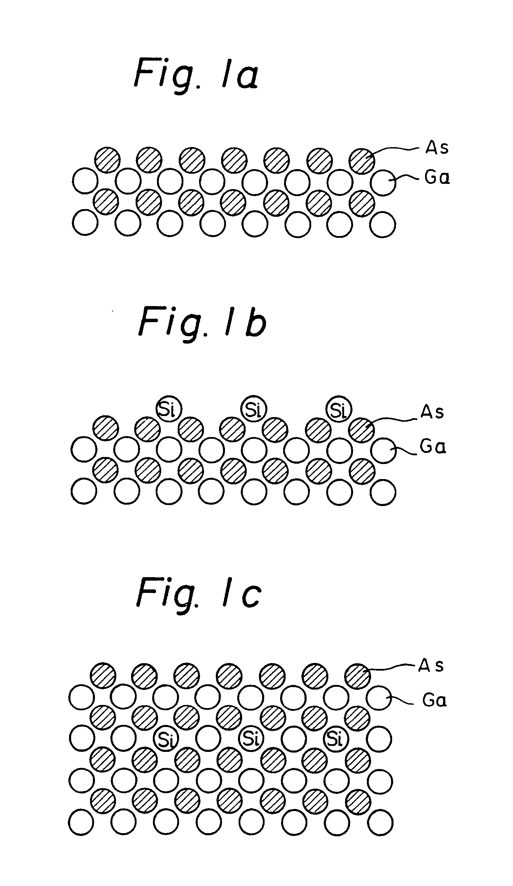

Referring to Figs. 1a to 1c, atomic plane doping of Si into a GaAs MBE layer is carried out in the following manner.

A (100) GaAs substrate has grown on it a GaAs layer by bombarding it with a Ga molecular beam and an As molecular beam simultaneously. When the Ga molecular beam is stopped with the As bombardment continued, the growth of the GaAs layer is suspended and an As surface appears, as shown in Fig. 1a. An Si molecular beam impinges on the As surface of the growing GaAs layer, so that Si atoms occupy some of the Ga sites, as shown in Fig. 1b. Then, the Si molecular beam is stopped and the Ga molecular beam is resumed, so that GaAs is grown, as shown in Fig. 1c. A plane comprising Si atoms is called an "atomic plane".

According to the present invention, this atomic plane doping is repeated and the dopant sheet concentration of each atomic plane and the interval between neighboring atomic planes are defined.

Next, the relationship between a sheet dopant (Si) concentration $N_{sd}$ (i.e., a doping amount of an atomic plane) and a sheet electron concentration $N_s$ is discussed.

A (100) GaAs substrate, a Ga effusion cell, an As effusion cell of Si effusion cell are set in an MBE apparatus. The MBE apparatus is evacuated to a high vacuum, and the substrate and the effusion cells are heated to prescribed temperature. For example, substrate temperature is 520°C (500°C to 700°C), the Ga effusion cell temperature is 1000°C (500°C to 1100C), the As effusion cell temperature is 330°C (300°C to 400°C), and the Si effusion cell temperature is 1300°C (1100°C to 1350°C). Each of the effusion cells is provided with a shutter which intercepts a molecular beam from the effusion cell.

A shutter of the As effusion cell is opened to allow the As molecular beam to impinge on the GaAs substrate. The substrate is cleaned by the As molecular beam. The shutter keeps on opening to continue the bombarding of the As molecular beam (i.e., As atoms) until the end of the GaAs layer formation. Then, a shutter of the Ga effusion cell is open to allow the Ga molecular beam to impinge, so that an undoped GaAs epitaxial layer (having a thickness of approximately 0.4 μm) is grown (at a growth rate of approximately 0.6 μm/h) on the substrate.

In order to perform Si atomic plane doping, the Ga molecular beam is stopped by closing the shutter of the Ga effusion cell to suspend the GaAs growth, and a shutter of the Si effusion cell is opened to allow the Si molecular beam to impinge on the growing GaAs layer. The Si atoms adhere to the As surface of the GaAs layer, as shown in Fig. 1b. At this time, the intensity of the Si molecular beam is controlled by adjusting the Si effusion cell temperature and the time for opening the Si cell shutter is controlled, so that the given sheet Si concentration (i.e., the prescribed number of Si atoms at an atomic plane) is attained.

Then, the Si cell shutter is closed and the Ga cell shutter is reopened, so that the Ga molecular beam impinges together with the As molecular beam on the GaAs layer to restart the growth of an undoped GaAs layer (having a thickness of approximately 0.1 μm).

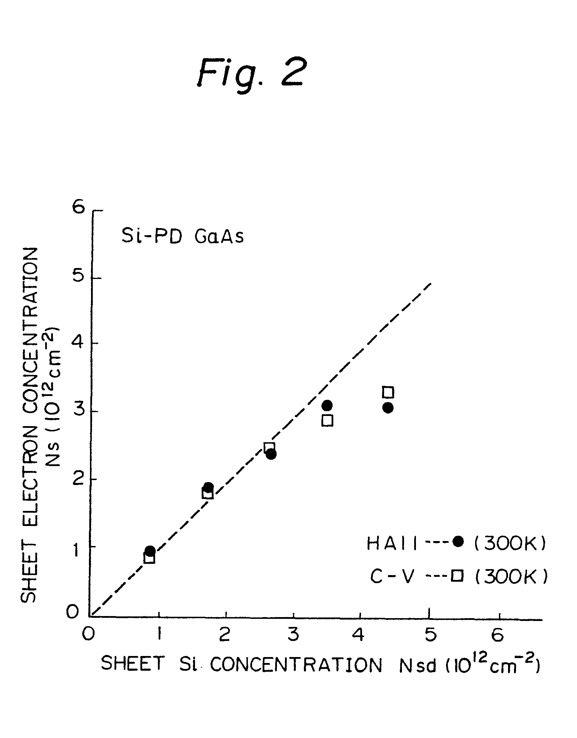

Thus each of the obtained GaAs MBE layers (having a thickness of approximately 0.5 μm) incorporates only one Si atomic plane having various sheet Si (dopant) concentrations $N_{sd}$. The sheet carrier electron concentrations $N_s$ of the GaAs layers are determined by Hall measurements and capacity-voltage (C-V) measurements. The results of the measurements at 300 K (27°C) are shown in Fig. 2. The broken line in Fig. 2 indicates the activation coefficient of 100 %. As shown in Fig. 2, Si atoms of up to $3 \times 10^{12}$ cm$^{-2}$ are completely activated. As the sheet Si concentration $N_{sd}$ increases, the sheet electron concentration $N_s$ increases, but the activation coefficient at $N_{sd}$ above $3 \times 10^{12}$ cm$^{-2}$ decreases and would reach a saturated value.

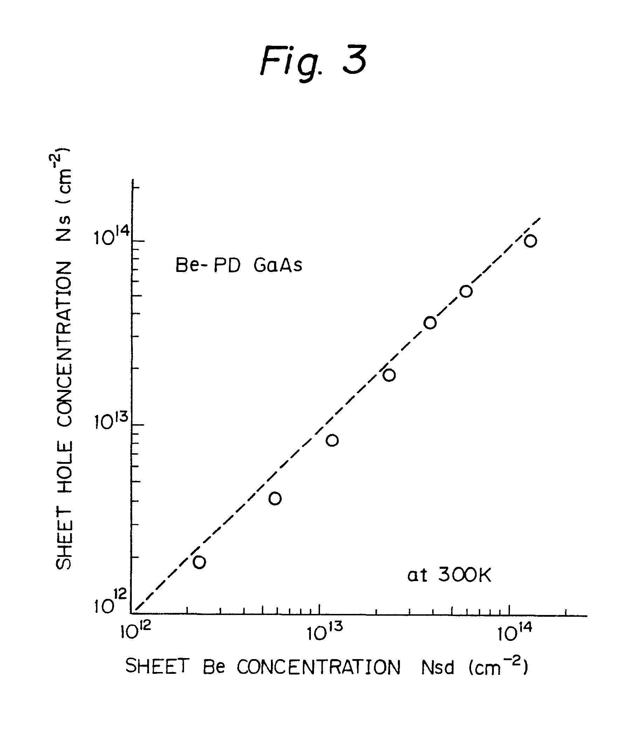

The relationship between a sheet Be concentration $N_{sd}$ and a sheet hole concentration $N_s$ is discussed. In the above-mentioned MBE growth of the GaAs layer, the effusion cell for Si is replaced with an effusion cell for Be for performing Be atomic plane doping. GaAs layers are formed under the above-mentioned conditions, so that each of the obtained GaAs MBE layers incorporates only one Be atomic plane having various sheet Be concentrations $N_{sd}$. The sheet carrier hole concentrations $N_s$ of the GaAs layers are determined by Hall measurements. The results of the measurements (at 300 K) are shown in Fig. 3. As shown in Fig. 3, Be atoms of up to $1.3 \times 10^{14}$ cm$^{-2}$ are almost completely activated.

A compound semiconductor MBE layer (e.g., GaAs layer) having a high carrier concentration is formed in accordance with the present invention.

## Example 1

A GaAs layer doped with Si by forming 20 Si atomic planes is produced in the following manner.

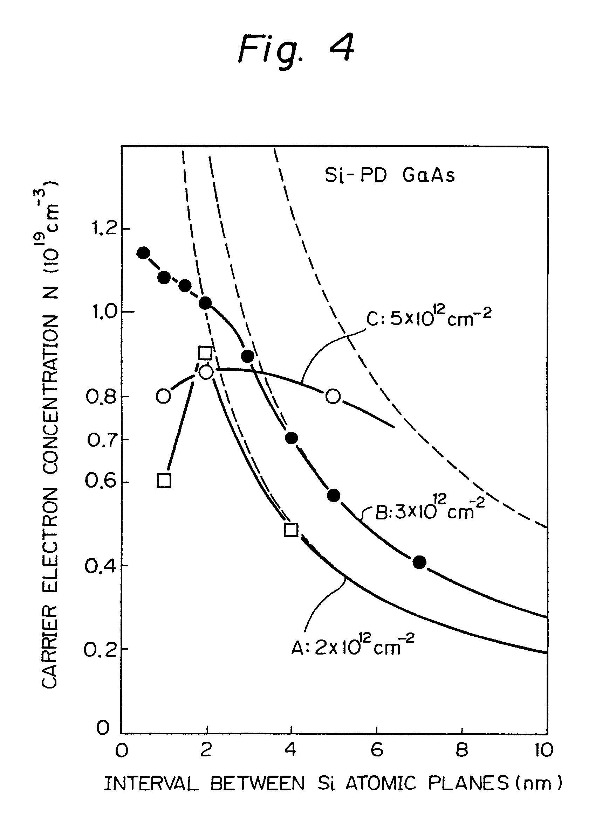

In an MBE apparatus, a (100) GaAs substrate is heated at approximately 520°C, and an As molecular be impinges on the substrate. These conditions are maintained. A Ga molecular beam impinges on the substrate to grow an undoped GaAs layer having a thickness of approximately 0.4 μm at a growth rate of approximately 0.6 μm/h. The Ga molecular beam is stopped to suspend the GaAs growth, and an Si molecular beam impinges on the GaAs layer to form an atomic plane. A sheet Si concentration $N_{sd}$ of the atomic plane of $2 \times 10^{12}$ cm$^{-2}$, $3 \times 10^{12}$ cm$^2$, or $5 \times 10^{12}$ cm$^{-2}$ attained by controlling the intensity and impinging time of the Si molecular beam. Then the Si molecular beam is stopped and the Ga molecular beam reimpinges to continue growing the GaAs layer. After the additional GaAs portion having a prescribed thickness (e.g., 0.5, 1.0, 1.5, 2, 3, 4, 4.5 or 7 nm) is grown on the atomic plane, the Ga molecular beam is stopped to resuspend the GaAs growth. The above-mentioned Si atomic plane doping is repeated. Thus, alternate Si atomic doping and additional GaAs portion growth are performed. After the 20th Si atomic plane doping, the final GaAs portion having a thickness of approximately 0.1 μm is grown. The obtained GaAs layer incorporates 20 Si atomic planes at constant intervals. The electron concentration N of the GaAs layer is determined by Hall measurements at 300 K. The results of the measurements are shown in Fig. 4. Solid curve lines A, B, and C indicate GaAs layers with Si atomic planes of $2 \times 10^{12}$, $3 \times 10^{12}$, and $5 \times 10^{12}$ cm$^{-2}$, respectively. Broken curve lines indicate calculated values. As can be seen from Fig. 4, in order to obtain a GaAs MBE layer having an electron concentration N of $0.7 \times 10^{19}$ cm$^{-3}$ or more, when the sheet Si concentration $N_{sd}$ is $2 \times 10^{12}$, $3 \times 10^{12}$ and $5 \times 10^{12}$ cm$^{-2}$, the interval between Si atomic planes is 2.5 nm or less, 4.0 nm or less, and 6 nm or less, respectively.

## Example 2

A GaAs layer doped with Be by forming 20 Be atomic planes is produced in the following manner.

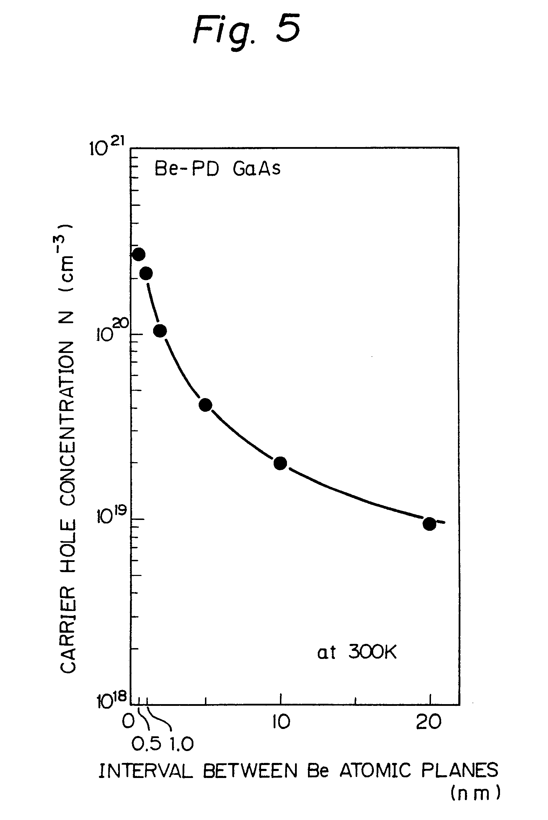

A (100) GaAs substrate has grown thereon an undoped GaAs layer (having a thickness of approximately 0.4 μm) under the same conditions as in Example 1. During the suspension of GaAs growth due to the stopping of the Ga molecular beam, a Be molecular beam impinges on the GaAs layer to form an atomic plane having a sheet Be concentration $N_{sd}$ of $2 \times 10^{13}$ cm$^{-2}$. Then, the Be molecular beam is stopped and the Ga molecular beam reimpinges to continue growing the GaAs layer. After the additional GaAs portion having a prescribed thickness (e.g., 0.5, 1.0, 2, 5, 10, or 20 nm) is grown on the atomic plane, the GaAs growth is resuspended by stopping of the Ga molecular beam. Such Be atomic plane doping and the additional GaAs portion growth are alternated. After the 20th Be atomic plane doping, the final GaAs portion having a thickness of approximately 0.1 μm is grown. The obtained GaAs layer incorporates 20 Be atomic planes at constant intervals. The average hole concentration N of the GaAs layer is determined by Hall measurements at 300 K. The results of the measurements are shown in Fig. 5. As can be seen from Fig. 5, the hole concentration is inversely proportional to the interval between the Be atomic planes. In order to obtain a GaAs MBE layer having a hole concentration N of $5 \times 10^{19}$ cm$^{-3}$ or more, when the sheet Be concentration $N_{sd}$ is $2 \times 10^{13}$ cm$^{-2}$, the interval is 4.0 nm or less. When the interval is 0.5 nm, the sheet Be concentration $N_{sd}$ reaches $2.8 \times 10^{20}$ cm$^{-3}$. From Figs. 3 and 5, it can be concluded that when the sheet Be concentration is small, the intervals are narrowed to attain a given hole concentration N, while when the sheet Be concentration is large, the intervals are widened. Therefore, by the adoption of suitable intervals for the Be atomic planes having a sheet Be concentration of $5 \times 10^{12}$ cm$^{-2}$ the given hole concentration can be attained.

It will be obvious that the present invention is not restricted to the above-mentioned embodiments and that many variations are possible for persons skilled in the art without departing from the scope of the invention. For example, it is possible to dope an AlGaAs MBE layer with Si or Be. For example, an AlGaAs MBE layer is formed in a semiconductor device utilizing a two-dimensional electron gas (2DEG), e.g., a high electron mobility transistor (HEMT), as an electron supply layer. A HEMT has a spacer layer of undoped AlGaAs between an undoped GaAs active layer and an electron supply layer of n-type AlGaAs. According to the prior art, e.g., the undoped AlGaAs spacer layer has a thickness of 6 nm, the n-type AlGaAs layer has a doping (Si) concentration of $2 \times 10^{18}$ cm$^{-3}$, and the sheet electron concentration of a 2DEG layer generated at the interface of undoped AlGaAs spacer layer and the GaAs active layer is $6 \times 10^{11}$ cm$^{-2}$. The Si atomic plane doping technique can be applied on the undoped AlGaAs spacer layer. During the growth of the AlGaAs spacer layer, a Ga molecular beam and an Al molecular beam are stopped to suspend the AlGaAs growth. A Si molecular beam impinges on the AlGaAs surface to form a Si atomic plane, and then the AlGaAs growth restarted. For example, the total thickness of the undoped AlGaAs layer is 12 nm and the Si atomic plane is formed at the center of the AlGaAs layer and has a sheet Si concentration of $2 \times 10^{12}$ cm$^{-2}$. n this case, a sheet electron concentration of a 2DEG layer can attain to $1 \times 10^{12}$ cm$^{-2}$. Thus, the Si atomic plane doping can increase the doping (dopant) amount of an AlGaAs layer for an electron supply layer. Therefore, where such Si atomic plane doping is repeated (i.e., Si atomic planes are formed) in an AlGaAs layer, the average dopant (Si) concentration is further increased with result that an electric resistant of the AlGaAs layer is decreased and an electron carrier concentration is increased.

## Claims

1. A compound semiconductor layer having a high carrier concentration comprising a semiconductor layer of GaAs or AlGaAs in which atomic planes of dopant are formed, characterized in that each of said atomic planes has a sheet dopant concentration of $2 \times 10^{12}$ cm$^{-2}$ or more and is spaced from other atomic planes by an interval of 6 nm or less, the carrier concentration of said GaAs or AlGaAs layer being $7 \times 10^{18}$ cm$^{-3}$ or more.

2. A compound semiconductor layer according to claim 1, characterized in that said compound semiconductor layer is given an N-type conductivity by using said atomic planes of Si dopant, each of said atomic planes has a sheet Si concentration of $2 \times 10^{12}$ cm$^{-2}$ or more, and said interval is 6 nm or less, so as to attain the Si concentration of said compound semiconductor layer of $7 \times 10^{18}$ cm$^{-3}$.

3. A compound semiconductor layer according to claim 1, characterized in that said compound semiconductor layer is given a P-type conductivity by using said atomic planes of Be dopant, each of said atomic planes has a sheet Be concentration of $5 \times 10^{12}$ cm$^{-2}$ or more, and said interval is 4 nm or less, so as to attain the Be concentration of said compound semiconductor layer of $1 \times 10^{20}$ cm$^{-3}$ or more.

## Patentansprüche

1. Verbindungshalbleiterschicht mit einer hohen Trägerkonzentration, die eine Halbleiterschicht aus GaAs oder AlGaAs umfaßt, in welcher atomare Ebenen von Dotierungsmitteln gebildet sind, dadurch gekennzeichnet, daß jede der genannten atomaren Ebenen eine Blatt-Dotierungskonzentration von $2 \times 10^{12}$ cm$^{-2}$ oder mehr hat und von anderen atomaren Ebenen um ein Intervall von 6 nm oder weniger entfernt ist, wobei die Trägerkonzentration der genannten GaAs- oder AlGaAs-Schicht $7 \times 10^{18}$ cm$^{-3}$ oder mehr beträgt.

2. Verbindungshalbleiterschicht nach Anspruch 1, dadurch gekennzeichnet, daß der genannten Verbindungshalbleiterschicht eine N-Typ-Leitfähigkeit gegebenen ist, durch Verwendung der genannten atomaren Ebenen aus Si-Dotierungsmittel, und jede der genannten atomaren Ebenen eine Blatt-Si-Konzentration von $2 \times 10^{12}$ cm$^{-2}$ oder mehr hat, und das genannte Intervall 6 nm oder kleiner ist, um so die Si-Konzentration der

Verbindungshalbleiterschicht von $7 \times 10^{18}$ cm$^{-3}$ zu erreichen.

3. Verbindungshalbleiterschicht nach Anspruch 1, dadurch gekennzeichnet, daß der genannten Verbindungshalbleiterschicht eine P-Typ-Leitfähigkeit gegebenen ist, durch Verwendung der genannten atomaren Ebenen aus Be-Dotierungsmittel, und jede der genannten atomaren Ebenen eine Blatt-Be-Konzentration von $5 \times 10^{12}$ cm$^{-2}$ oder mehr hat, und das genannte Intervall 4 nm oder kleiner ist, um so die Be-Konzentration der genannten Verbindungshalbleiterschicht von $1 \times 10^{20}$ cm$^{-3}$ oder mehr zu erreichen.

## Revendications

1. Couche semiconductrice composée possè-dant une concentration élevée en porteurs, comprenant une couche semiconductrice de GaAs ou de AlGaAs dans laquelle des plans atomiques d'agent dopant sont formés, caractérisée en ce que chacun desdits plans atomiques possède une concentration pelliculaire en agent dopant de $2 \times 10^{12}$ cm$^{-2}$, ou plus, et est écartée d'autres plans atomiques par un intervalle de 6 nm, ou moins, la concentration en porteurs de la couche de GaAs ou de AlGaAs étant de $7 \times 10^{18}$ cm$^{-3}$, ou plus.

2. Couche semiconductrice composée selon la revendication 1, caractérisée en ce que ladite couche semiconductrice composée se voit donner une conductivité du type N par l'utilisation desdits plans atomiques d'agent dopant Si, chacun desdits plans atomiques possède une concentration pelliculaire en Si de $2 \times 10^{12}$ cm$^{-2}$, ou plus, et ledit intervalle est de 6 nm, ou moins, de sorte qu'il est obtenu une concentration en Si de $7 \times 10^{18}$ cm$^{-3}$ pour ladite couche semiconduc-trice composée.

3. Couche semiconductrice composée selon la revendication 1, caractérisée en ce que ladite couche semiconductrice composée se voit donner une conductivité du type P par utilisation desdits plans atomiques d'agent dopant Be, chacun desdits plans atomiques possède une concentration pelliculaire en Be de $5 \times 10^{12}$ cm$^{-2}$, ou plus, et ledit intervalle est de 4 nm, ou moins, si bien qu'il est obtenu une concentration en Be de $1 \times 10^{20}$ cm$^{-3}$, ou plus, pour ladite couche semiconductrice composée.

# Fig. Ia

# Fig. Ib

# Fig. Ic

# Fig. 2

Si-PD GaAs

SHEET ELECTRON CONCENTRATION Ns ($10^{12}$ cm$^{-2}$)

HAll --- ● (300K)
C - V --- □ (300K)

SHEET Si CONCENTRATION Nsd ($10^{12}$ cm$^{-2}$)

# *Fig. 3*

# Fig. 4

# Fig. 5

Graph: Be-PD GaAs. Y-axis: CARRIER HOLE CONCENTRATION N (cm$^{-3}$), from $10^{18}$ to $10^{21}$. X-axis: INTERVAL BETWEEN Be ATOMIC PLANES (nm), from 0 to 20 with markings at 0.5, 1.0, 10, 20. at 300K